(19) Europäisches Patentamt
European Patent Office
Office européen des brevets

(11) EP 4 307 357 A1

(12) **EUROPEAN PATENT APPLICATION**
published in accordance with Art. 153(4) EPC

(43) Date of publication:
**17.01.2024 Bulletin 2024/03**

(21) Application number: **22766986.8**

(22) Date of filing: **03.03.2022**

(51) International Patent Classification (IPC):
***H01L 23/02*** *(2006.01)* ***H01L 23/10*** *(2006.01)*

(52) Cooperative Patent Classification (CPC):
**H01L 23/02; H01L 23/10**

(86) International application number:
**PCT/JP2022/009119**

(87) International publication number:
**WO 2022/191028 (15.09.2022 Gazette 2022/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.03.2021 JP 2021037215**

(71) Applicant: **Tomoegawa Co., Ltd.**
**Tokyo 104-8335 (JP)**

(72) Inventors:
- **MATSUNAGA Yuuki**
  **Shizuoka-shi, Shizuoka 424-0831 (JP)**
- **KOMAGATA Fumiki**
  **Shizuoka-shi, Shizuoka 424-0831 (JP)**
- **TOMIOKA Ayana**
  **Shizuoka-shi, Shizuoka 424-0831 (JP)**

(74) Representative: **V.O.**
**P.O. Box 87930**
**2508 DH Den Haag (NL)**

(54) **ELECTRONIC COMPONENT SEALING LID**

(57) The present invention provides an electronic component sealing lid that suppresses detachment caused by reflow treatment, wherein the sealing lid is formed from a resin composition containing a liquid crystal polymer and an inorganic substance, and satisfies either the following formula (a) or formula (b). (a): $T1/T2 < 0.9$, (b): $T1/T2 > 1.1$ [wherein $T1=S1/S2$, $T2=S3/S4$, S1 is the area of the region obtained by connecting, with a straight line, the inverse peak nearest to 900 $cm^{-1}$ and the inverse peak nearest to 860 $cm^{-1}$ in the absorbance distribution of the bonding surface of the lid, S2 is the area of the region obtained by connecting, with a straight line, the inverse peak nearest to 900 $cm^{-1}$ and the inverse peak nearest to 770 $cm^{-1}$ in the absorbance distribution of the bonding surface of the lid, S3 is the area of the region obtained by connecting, with a straight line, the inverse peak nearest to 900 $cm^{-1}$ and the inverse peak nearest to 860 $cm^{-1}$ in the absorbance distribution of the portion of the lid that is not the bonding surface, and S4 is the area of the region obtained by connecting, with a straight line, the inverse peak nearest to 900 $cm^{-1}$ and the inverse peak nearest to 770 $cm^{-1}$ in the absorbance distribution of the portion of the lid that is not the bonding surface].

FIG. 1A

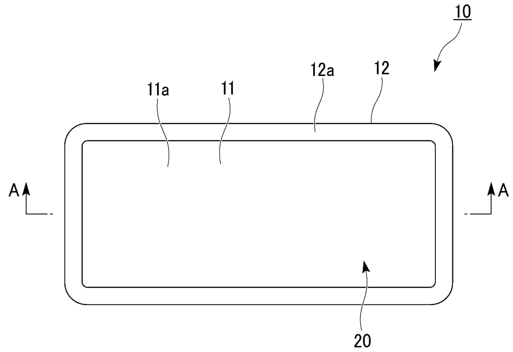


EP 4 307 357 A1

## Description

[Technical Field]

The present invention relates to an electronic component sealing lid.

Priority is claimed on Japanese Patent Application No. 2021-037215, filed March 9, 2021, the content of which is incorporated herein by reference.

[Background Art]

Conventionally, radio frequency (RF) power devices (hereinafter referred to as "RF power devices") having chips mounted on a ceramic package obtained by laminating a copper heat sink and a ceramic substrate have used an airtight sealing lid to cover the semiconductor elements, the mounting surface of the substrate, and the space created by the resin framing and the like. A ceramic lid (having a cap shape) coated with an epoxy-based adhesive is typically used as this airtight sealing lid.

With the expansion of the RF power devices market due to the increase in 5G wireless base stations, the price of RF power devices has continued to fall. However, due to the oligopoly of ceramic package manufacturers, the ceramic packages that represent one of the structural components of RF power devices have not undergone significant cost reductions. Accordingly, the manufacturers of RF power devices have been investigating the use of plastic packages and plastic lids.

The plastics used for lids require reflow resistance. Accordingly, examples of the plastics used for lids include highly heat-resistant resins known as engineering plastics and super engineering plastics. For example, liquid crystal polymers (hereinafter abbreviated as "LCP") can be used as highly heat-resistant resins. However, LCP lids have had problems, including poor adhesiveness, and peeling between the lid and the package body following reflow treatment.

For example, in Patent Document 1, an LCP is used as the resin that constitutes a lid for a semiconductor element mounting package. However, the LCP lid has low adhesiveness. As a result, the LCP lid suffers from detachment of the lid from the package body following the reflow treatment conducted during production of the semiconductor element mounting package.

Accordingly, in Patent Document 2, in order to improve the adhesiveness of LCP lids, the surface of the LCP lid is subjected to a sandblasting treatment or the like. Subjecting the surface of the lid to a sandblasting treatment of the like to increase the surface roughness of the lid surface aims to provide an anchoring effect on the lid surface.

[Citation List]

[Patent Documents]

[Patent Document 1]
Japanese Unexamined Patent Application, First Publication No. 2016-76669
[Patent Document 2]
Japanese Unexamined Patent Application, First Publication No. Hei 01-236246

[Summary of Invention]

[Problems to be Solved]

However, Patent Document 2 only discloses the conducting of a sandblasting treatment or the like to improve the adhesiveness of an LCP lid. In other words, Patent Document 2 made no investigation of the degree of sandblasting treatment required to impart a satisfactory level of adhesiveness to the LCP lid.

The present invention has been developed in light of the above circumstances, and has an object of providing an electronic component sealing lid which contains a liquid crystal polymer and suppresses detachment caused by reflow treatment.

[Means for Solving the Problems]

The present invention has the following aspects.

[1] An electronic component sealing lid which is formed from a resin composition containing a liquid crystal polymer and an inorganic substance, and satisfies either formula (a) or formula (b) shown below.

$$T1/T2 < 0.9 \qquad (a)$$

$$T1/T2 > 1.1 \qquad (b)$$

[T1=S1/S2. T2=S3/S4. S1 is the area of the region obtained by connecting, with a straight line, the inverse peak nearest to 900 $cm^{-1}$ and the inverse peak nearest to 860 $cm^{-1}$ in the absorbance distribution, measured by Fourier transform infrared spectroscopy, of the resin composition of the bonding surface of the electronic component sealing lid. S2 is the area of the region obtained by connecting, with a straight line, the inverse peak nearest to 900 $cm^{-1}$ and the inverse peak nearest to 770 $cm^{-1}$ in the absorbance distribution, measured by Fourier transform infrared spectroscopy, of the bonding surface of the electronic component sealing lid. S3 is the area of the region obtained by connecting, with a straight line, the inverse peak nearest to 900 $cm^{-1}$ and the inverse peak nearest to 860 $cm^{-1}$ in the absorbance distribution, measured by Fourier transform infrared spectroscopy, of the surface of the portion of the electronic component sealing lid that is not the bonding surface. S4 is the area of the region obtained by connecting, with a straight line, the inverse peak nearest to 900 $cm^{-1}$ and the inverse peak nearest to 770 $cm^{-1}$ in the absorbance distribution, measured by Fourier transform infrared spectroscopy, of the surface of the portion of the electronic component sealing lid that is not the bonding surface.]

[2] The electronic component sealing lid according to [1], wherein the arithmetic average roughness (Ra) of the bonding surface of the electronic component sealing lid is at least 0.3 $\mu$m but not more than 20 $\mu$m.

[3] The electronic component sealing lid according to [1] or [2], wherein the amount of the inorganic substance is at least 10 parts by mass but not more than 60 parts by mass per 100 parts by mass of the liquid crystal polymer.

[4] The electronic component sealing lid according to [2] or [3], wherein an adhesive layer is laminated onto the bonding surface, and the adhesive layer contains a thermosetting resin and a curing agent.

[5] The electronic component sealing lid according to [4], wherein the adhesive layer contains a silane coupling agent.

[6] The electronic component sealing lid according to [4] or [5], wherein the amount of the thermosetting resin is at least 1% by mass but not more than 80% by mass of the total mass of the adhesive layer.

[7] The electronic component sealing lid according to any one of [4] to [6], wherein the content ratio of the curing agent relative to the thermosetting resin, expressed as an equivalence ratio, is at least 0.2 but not more than 1.

[Effects of the Invention]

The present invention is able to provide an electronic component sealing lid which contains a liquid crystal polymer and suppresses detachment caused by reflow treatment.

[Brief Description of Drawings]

FIG. 1A is a plan view of a schematic outline illustrating the electronic component sealing lid according to an embodiment of the present invention.

FIG. 1B is a schematic outline illustrating the electronic component sealing lid according to an embodiment of the present invention, and represents a cross-sectional view along the line A-A of FIG. 1A.

FIG. 2 is a diagram illustrating a method for determining the area of the region obtained by connecting, with a straight line, the inverse peak nearest to 900 $cm^{-1}$ and the inverse peak nearest to 860 $cm^{-1}$ in the absorbance distribution, measured by Fourier transform infrared spectroscopy (FT-IR), of either the bonding surface of the electronic component sealing lid according to an embodiment of the present invention, or the surface of the portion of the electronic component sealing lid that is not the bonding surface, for example, the aforementioned S1 or S3.

FIG. 3 is a diagram illustrating a method for determining the area of the region obtained by connecting, with a straight line, the inverse peak nearest to 900 $cm^{-1}$ and the inverse peak nearest to 770 $cm^{-1}$ in the absorbance distribution, measured by Fourier transform infrared spectroscopy (FT-IR), of either the bonding surface of the electronic component sealing lid according to an embodiment of the present invention, or the surface of the portion of the electronic component sealing lid that is not the bonding surface, for example, the aforementioned S2 or S4.

FIG. 4 is a schematic cross-sectional view illustrating the electronic component sealing lid according to an embodiment of the present invention.

[Embodiments for Carrying Out the Invention]

Embodiments of the electronic component sealing lid according to the present invention are described below with reference to the drawings. It should be noted that the drawings used in the following description may sometimes be drawn with characteristic portions enlarged as appropriate, and the dimensional ratios and the like between the constituent elements may differ from the actual values. Further, the materials and dimensions and the like presented in the following description are merely examples, which in no way limit the present invention, and may be altered as appropriate within the scope of the present invention.

[Electronic Component Sealing Lid]

The electronic component sealing lid according to one embodiment of the present invention is formed from a resin composition containing a liquid crystal polymer and an inorganic substance,
and satisfies either formula (a) or formula (b) shown below.

$$T1/T2 < 0.9 \qquad (a)$$

$$T1/T2 > 1.1 \qquad (b)$$

[T1=S1/S2. T2=S3/S4. S1 is the area of the region obtained by connecting, with a straight line, the inverse peak nearest to 900 $cm^{-1}$ and the inverse peak nearest to 860 $cm^{-1}$ in the absorbance distribution, measured by Fourier transform infrared spectroscopy, of the resin composition of the bonding surface of the electronic component sealing lid. S2 is the area of the region obtained by connecting, with a straight line, the inverse peak nearest to 900 $cm^{-1}$ and the inverse peak nearest to 770 $cm^{-1}$ in the absorbance distribution, measured by Fourier transform infrared spectroscopy, of the bonding surface of the electronic component sealing lid. S3 is the area of the region obtained by connecting, with a straight line, the inverse peak nearest to 900 $cm^{-1}$ and the inverse peak nearest to 860 $cm^{-1}$ in the absorbance distribution, measured by Fourier transform infrared spectroscopy, of the surface of the portion of the electronic component sealing lid that is not the bonding surface. S4 is the area of the region obtained by connecting, with a straight line, the inverse peak nearest to 900 $cm^{-1}$ and the inverse peak nearest to 770 $cm^{-1}$ in the absorbance distribution, measured by Fourier transform infrared spectroscopy, of the surface of the portion of the electronic component sealing lid that is not the bonding surface.]

The electronic component sealing lid of the present embodiment is described below with reference to FIG. 1A and FIG. 1B.

FIG. 1A and FIG. 1B are a pair of schematic outlines illustrating the electronic component sealing lid according to the present embodiment, wherein FIG. 1A is a plan view and FIG. 1B is a cross-sectional view along the line A-A of FIG. 1A.

The electronic component sealing lid 10 of the embodiment illustrated in FIG. 1 is formed from a resin composition containing a liquid crystal polymer and an inorganic substance.

The electronic component sealing lid 10 of the present embodiment includes a base section 11 and a wall section 12. The base section 11 is a rectangular sheet-like region when viewed in plain view. The wall section 12 is a protruding region which protrudes in the thickness direction of the base section 11 from one surface 11a of the base section 11. Further, the wall section 12 functions as the edge of the base section 11 on the one surface side 11a of the base section 11. The electronic component sealing lid 10 has a space 20 surrounded by the base section 11 and the wall section 12. An electronic component such as a semiconductor chip is accommodated within this space 20. The surface (the upper surface in FIG. 1) 12a of the wall section 12 on the opposite side to the surface 11a of the base section 11 functions as the bonding surface 10a of the electronic component sealing lid 10. The bonding surface 10a of the electronic component sealing lid 10 is the surface that is bonded to the main body of the electronic component package in order to enable the electronic component sealing lid 10 to seal the electronic component, and is the surface on which an adhesive layer is provided.

The electronic component sealing lid 10 according to the present embodiment satisfies either formula (a) or formula (b) shown below.

$$T1/T2 < 0.9 \qquad (a)$$

$$T1/T2 > 1.1 \qquad (b)$$

In the above formula (a) and formula (b), T1=S1/S2 (hereinafter referred to as "formula (c)"), and T2=S3/S4 (hereinafter referred to as "formula (d)"),

S1 in formula (c) is the area of the region obtained by connecting, with a straight line $\alpha$, the inverse peak A nearest to 900 $cm^{-1}$ and the inverse peak B nearest to 860 $cm^{-1}$ in the absorbance distribution, measured by Fourier transform infrared spectroscopy (FT-IR), of the bonding surface 10a of the electronic component sealing lid 10 (see FIG. 2). In FIG. 2 which illustrates the method for determining this area, the vertical axis indicates the absorbance [A] and the horizontal axis indicates the wavenumber.

S2 in formula (c) is the area of the region obtained by connecting, with a straight line $\beta$, the inverse peak C nearest to 900 $cm^{-1}$ and the inverse peak D nearest to 770 $cm^{-1}$ in the absorbance distribution, measured by Fourier transform infrared spectroscopy (FT-IR), of the bonding surface 10a of the electronic component sealing lid 10 (see FIG. 3). In FIG. 3 which illustrates the method for determining this area, the vertical axis indicates the absorbance [A] and the horizontal axis indicates the wavenumber.

S3 in formula (d) is the area of the region obtained by connecting, with a straight line $\alpha$, the inverse peak A nearest to 900 $cm^{-1}$ and the inverse peak B nearest to 860 $cm^{-1}$ in the absorbance distribution, measured by Fourier transform infrared spectroscopy (FT-IR), of the surface of the portion of the electronic component sealing lid 10 that is not the bonding surface 10a (for example, in FIG. 1A and FIG. 1B, the surface 11a of the base section 11).

S4 in formula (d) is the area of the region obtained by connecting, with a straight line $\beta$, the inverse peak C nearest to 900 $cm^{-1}$ and the inverse peak D nearest to 770 $cm^{-1}$ in the absorbance distribution, measured by Fourier transform infrared spectroscopy (FT-IR), of the surface of the portion of the electronic component sealing lid 10 that is not the bonding surface 10a.

In the method for measuring the absorbance distribution of the bonding surface 10a of the electronic component sealing lid 10 and the surface of the portion of the electronic component sealing lid 10 that is not the bonding surface 10a by Fourier transform infrared spectroscopy (FT-IR), a Fourier transform infrared spectrophotometer (Spectrum 100, manufactured by PerkinElmer, Inc.) is used, the measurement target surface of the electronic component sealing lid is brought into contact with the ATR crystal, and the absorbance is measured by the ATR method. As the measurement samples, six random points on both the adhesive-coated surface and the non-adhesive-coated surface were used for measurement.

The arithmetic average roughness (Ra) of the bonding surface 10a of the electronic component sealing lid 10 is preferably at least 0.3 $\mu$m but not more than 20 $\mu$m, and more preferably at least 0.5 $\mu$m but not more than 10 $\mu$m. Provided the arithmetic average roughness (Ra) of the bonding surface 10a of the electronic component sealing lid 10 falls within the above range, satisfactory adhesive strength can be achieved.

The arithmetic average roughness (Ra) of the bonding surface 10a of the electronic component sealing lid 10 can be measured using a laser microscope.

When liquid crystal polymers are molded in a mold, a thin layer (skin layer) in which the liquid crystal polymer is aligned along the surface of the mold is formed on the surfaces of the molded article that contact the mold (for example, the bonding surface 10a of the electronic component sealing lid 10 and the surface 11a of the base section 11). If an adhesive layer is formed on the surface of the molded article with this skin layer still remaining, and the molded article is then bonded to a bonding target object, the skin layer may detach from the molded article, causing the molded article to peel away from the bonding target object. Accordingly, in the electronic component sealing lid 10 of the present embodiment, the skin layer that exists at the surface that is to act as the bonding surface 10a is subjected to lap polishing to form the bonding surface 10a. In other words, lap polishing is used to adjust the arithmetic average roughness (Ra) of the bonding surface 10a of the electronic component sealing lid 10 to a value within the above range. In the electronic component sealing lid 10 of the present embodiment, an adhesive is applied to the bonding surface 10a formed by lap polishing to form an adhesive layer composed of the adhesive.

Because an adhesive layer is not formed on the portion of the electronic component sealing lid 10 that is not the bonding surface, lap polishing of the surface of this portion of the electronic component sealing lid 10 that is not the bonding surface need not be performed.

At the bonding surface 10a of the electronic component sealing lid 10, the exposed area percentage for the inorganic substance is preferably at least 5%, more preferably at least 7%, and even more preferably 9% or higher. Provided the exposed area percentage for the inorganic substance is at least 5%, the adhesiveness of the bonding surface 10a of the electronic component sealing lid 10 is satisfactory, and detachment of the electronic component sealing lid 10 from the main body of the electronic component package during reflow durability testing can be suppressed.

The exposed area percentage for the inorganic substance at the bonding surface 10a of the electronic component sealing lid 10 refers to the area of exposed inorganic substance at the bonding surface 10a relative to a value of 100% for the total area of the bonding surface 10a including the exposed inorganic substance.

There are no particular limitations on the thickness t1 of the base section 11.
There are no particular limitations on the height h1 of the wall section 12 from one surface 11a of the base section 11.
There are no particular limitations on the width w1 of the wall section 12.

[Liquid Crystal Polymer]

In the electronic component sealing lid 10 of the present embodiment, the liquid crystal polymer is preferably a polyester known as a thermotropic liquid crystal polymer.
Polycondensates of ethylene terephthalate and para-hydroxybenzoic acid, represented by formula (1) shown below, are preferred as the liquid crystal polymer. Specific examples of liquid crystal polymers represented by formula (1) include SIVERIS (a brand name) manufactured by Toray Industries, Inc.

[Chemical formula 1]

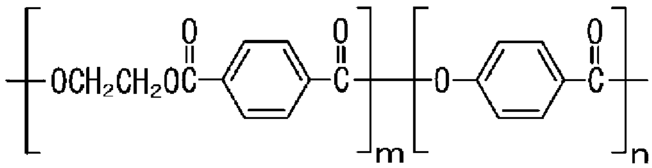

(1)

Polycondensates of phenol, phthalic acid and para-hydroxybenzoic acid (a polycondensate of 4,4-dihydroxybiphenol and terephthalic acid), represented by formula (2) shown below, are also preferred as the liquid crystal polymer. Specific examples of liquid crystal polymers represented by formula (2) include SUMIKASUPER (a brand name) manufactured by Sumitomo Chemical Co., Ltd., and XYDAR (a brand name) manufactured by ENEOS Corporation.

[Chemical formula 2]

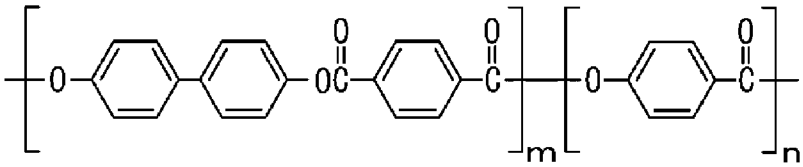

(2)

Polycondensates of 2,6-hydroxynaphthoic acid and para-hydroxybenzoic acid, represented by formula (3) shown below, are also preferred as the liquid crystal polymer. Specific examples of liquid crystal polymers represented by formula (3) include LAPEROS (a brand name) manufactured by Polyplastics Corporation.

[Chemical formula 3]

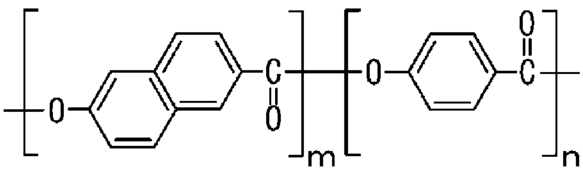

(3)

[Inorganic Substance]

Examples of the inorganic substance include talc, mica, clay, sericite, calcium carbonate, calcium silicate, silica, alumina, aluminum hydroxide, magnesium hydroxide, graphite, glass fiber, and carbon fiber.
In the electronic component sealing lid 10 of the present embodiment, the amount of the inorganic filler, per 100 parts by mass of the liquid crystal polymer, is preferably at least 10 parts by mass but not more than 60 parts by mass, and more preferably at least 20 parts by mass, but not more than 50 parts by mass. If the amount of the inorganic filler is less than the above lower limit, then a deterioration in the anisotropy suppression effect of the molded body may result in worse warping or a decrease in weld strength. If the amount of the inorganic substance exceeds the above

upper limit, then the fluidity during the molded body molding step tends to deteriorate.

The average particle size of the inorganic substance is preferably at least 1 μm but not more than 50 μm, and more preferably at least 5 μm but not more than 20 μm. Provided the average particle size of the inorganic substance falls within this range, the adhesiveness at the bonding surface 10a of the electronic component sealing lid 10 can be further improved.

The average particle size of the inorganic substance can be measured by performing an SEM analysis of a cross-section of the molded body, and then conducting image analysis.

[Other Components]

The electronic component sealing lid 10 of the present embodiment may, if necessary, also contain various additives such as antistatic agents, heat stabilizers, light stabilizers, flame retardants, lubricants, inorganic colorants, organic colorants, surface smoothing agents, surface gloss improvers, and mold release improvers such as fluororesins.

Because the electronic component sealing lid 10 of the present embodiment satisfies either formula (a): $T1/T2 < 0.9$ or formula (b): $T1/T2 > 1.1$, the adhesiveness at the bonding surface 10a of the electronic component sealing lid 10 is excellent, and detachment from the main body of the electronic component package as a result of reflow treatment can be suppressed.

[Method for Producing Electronic Component Sealing Lid]

A method for producing an electronic component sealing lid according to one embodiment of the present invention includes a preformed body molding step of molding a preformed body containing the liquid crystal polymer and the inorganic substance, a molded body molding step of subjecting the preformed body to pressurized heating to obtain a molded body, and a polishing step of polishing a surface (that becomes the bonding surface) of the molded body to expose the inorganic substance.

[Preformed Body Molding Step]

In the preformed body molding step, the resin composition containing a powder of the liquid crystal polymer and the inorganic substance is placed in a mold having a prescribed shape and volume, and is then compressed by cold pressing to mold a preformed body.

In the preformed body molding step, an amount of the liquid crystal polymer calculated from the volume of the mold, the specific gravity of the liquid crystal polymer and the bulk density of the liquid crystal polymer is placed in the mold, and that liquid crystal polymer is compressed by cold pressing to mold a preformed body.

[Molded Body Molding Step]

In the molded body molding step, the preformed body obtained in the preformed body molding step is heated and pressurized to obtain a molded body.

In the molded body molding step, the preformed body is removed from the mold and placed in a separate mold, or the mold used in the production step for the preformed body is simply reused, and either a compression plate (metal plate) is used to cover the upper surface of the mold or an inner lid is formed with a metal plate, and subsequently, a compression molding apparatus is then used to heat and pressurize the preformed body to obtain a molded body containing the aforementioned base section 11 and inorganic substance 12. The obtained molded body is cooled to room temperature and then removed from the mold.

[Polishing Step]

In the polishing step, the surface of the molded body (the surface that becomes the bonding surface 10a of the electronic component sealing lid 10) is polished to adjust the arithmetic average roughness (Ra) of the surface to a value within the range described above.

When the liquid crystal polymer is molded in the mold, a thin layer (skin layer) in which the liquid crystal polymer is aligned along the surface of the mold is formed on the surfaces of the molded body that contact the mold. The thickness of this skin layer is about 1 μm to 2 μm. Accordingly, in the polishing step, by removing at least 2 μm from the surface of the molded body, the skin layer can be removed, exposing the inorganic substance at the surface of the molded body. The degree of polishing of the molded body surface (the amount of polishing in the thickness direction of the molded body) is preferably adjusted so that the surface of the molded body (the surface that becomes the bonding surface 10a of the electronic component sealing lid 10) develops an arithmetic surface roughness (Ra) of at least 0.3 μm but not

more than 20 μm.

There are no particular limitations on the polishing method used in the polishing step, and examples include lap polishing, whetstone polishing, blast polishing, buff polishing, and grinding.

By conducting the above steps, the electronic component sealing lid 10 of the present embodiment can be obtained.

<Other Embodiments>

The present invention is not limited to the embodiment described above.

For example, an electronic component sealing lid 30 according to a modification such as that illustrated in FIG. 4 may be employed. In the electronic component sealing lid 30 according to this modification, portions that represent the same structural elements as in the embodiment described above are labeled with the same reference symbols, and description of those portions is omitted, with only the points of difference being described below.

The electronic component sealing lid 30 according to the modification illustrated in FIG. 4 includes the electronic component sealing lid 10 of the embodiment described above, and an adhesive layer 31. In other words, the electronic component sealing lid 30 includes the electronic component sealing lid 10, and the adhesive layer 31 that is laminated to the bonding surface 10a of the electronic component sealing lid 10.

The adhesive layer 31 contains a thermosetting resin and a curing agent. In other words, the adhesive layer 31 is formed from an adhesive containing the thermosetting resin and the curing agent.

The thickness of the adhesive layer 31 is preferably at least 30 μm but not more than 300 μm, and more preferably at least 50 μm but not more than 200 μm. If the thickness of the adhesive layer 31 is less than the above lower limit, then the amount of the adhesive tends to be insufficient to spread adequately across the bonding surface, which may cause a deterioration in the adhesive strength or unsatisfactory airtightness. If the thickness of the adhesive layer 31 exceeds the above upper limit, then internal pressure increases caused by volume shrinkage and temperature increase during pressure bonding at the time of sealing tend to result in the formation of air passages that cause leakage from the interior of the bonding surface, meaning airtightness cannot be ensured.

[Thermosetting Resin]

Examples of the thermosetting resin include phenol resins, furan resins, epoxy resins, unsaturated polyester resins, polyimide resins, urea resins and melamine resins. Among these, in terms of the heat resistance, adhesive strength, airtightness, dimensional stability and chemical resistance, epoxy resins are particularly desirable.

The epoxy resin is, for example, preferably at least one type of liquid epoxy resin selected from the group consisting of bisphenol A diglycidyl ether, bisphenol F diglycidyl ether, hydrogenated bisphenol A diglycidyl ether, and glycidylamine. Among the various epoxy resins, in terms of the ease of coating onto the main body of the electronic component package and the electronic component sealing lid, resins that are liquid at room temperature are preferred. However, even epoxy resins that are solid at room temperature can be used, for example, by mixing with a liquid epoxy resin or by adding a reactive diluent.

Further, epoxy resins that are solid at room temperature may also be used by increasing the temperature during coating, thereby lowering the viscosity of the resin. Moreover, epoxy resins that are solid at room temperature may also be used by dispersion in a liquid curing agent or reactive diluent.

The amount of the thermosetting resin, relative to the total mass of the adhesive layer 31, is preferably at least 30% by mass but not more than 80% by mass, and more preferably at least 50% by mass but not more than 80% by mass. Provided the amount of the thermosetting resin is at least 30% by mass, satisfactory heat resistance can be achieved for the adhesive layer 31. Provided the amount of the thermosetting resin is not more than 80% by mass, problems such as increases in the internal stress of the adhesive layer 31, increased brittleness of the adhesive layer 31, causing a deterioration in the heat resistance reliability, and worsening of the workability associated with forming the adhesive layer 31 can be better suppressed. Further, if the amount of the thermosetting resin is at least 50% by mass but not more than 80% by mass, then an adhesive layer 31 having comparatively low internal stress and a high glass transition temperature can be formed, meaning an electronic component sealing lid 30 having excellent heat resistance reliability can be obtained.

[Curing Agent]

In the electronic component sealing lid 30 of the present embodiment, the adhesive layer 31 contains a curing agent. The curing agent is preferably an aromatic amine such as diaminodiphenylmethane or diaminodiphenylsulfone, or an alicyclic amine.

The content ratio of the curing agent relative to the thermosetting resin, expressed as an equivalence ratio, is

preferably at least 0.2 but not more than 1, and more preferably at least 0.2 but not more than 0.7. Provided the content ratio of the curing agent satisfies this range, the heat resistance of the adhesive layer 31 and the workability associated with forming the adhesive layer 31 both improve.

[Other Components]

The adhesive layer 31 may also contain a stabilizer.

For the stabilizer, either a borate ester may be used alone, or a combination of a borate ester and a phenol resin may be used. The borate ester is either an alkyl ester of boric acid or an aryl ester of boric acid. Specific examples of the borate ester include trimethyl borate, triethyl borate, tributyl borate, and triphenyl borate.

In the electronic component sealing lid 30 of the present embodiment, the amount of the borate ester is preferably at least 5 parts by mass but not more than 15 parts by mass, per 100 parts by mass of the thermosetting resin. Provided the amount of the borate ester is at least as large as the above lower limit, a storage stability improvement effect can be achieved for the adhesive layer 31. Provided the amount of the borate ester is not more than the above upper limit, there is no reduction in the curing reactivity of the adhesive layer 31.

The adhesive layer 31 preferably also contains an elastomer for the purposes of improving the adhesion and bonding with the main body of the electronic component package, and moderating any stress that develops between the electronic component sealing lid 30 and the above main body during bonding.

There are no particular limitations on the elastomer, and examples include rubbers and thermoplastic elastomers (hereinafter abbreviated as "TPE"). Specific examples of the rubbers include isoprene rubber, butadiene rubber, styrene-butadiene rubber, chloroprene rubber, nitrile rubber, butyl rubber, ethylene-propylene rubber, acrylic rubber, silicone rubber, fluororubber, urethane rubber and polysulfide rubber. Examples of the TPE include styrene-based TPE, olefin-based TPE, urethane-based TPE, ester-based TPE, amide-based TPE, natural rubber-based TPE, and polyvinyl chloride (PVC)-based TPE. One of these elastomers may be used alone, or a combination of two or more elastomers may be used.

In the electronic component sealing lid 30 of the present embodiment, the amount of the elastomer is preferably at least 5 parts by mass but not more than 15 parts by mass, per 100 parts by mass of the thermosetting resin. Provided the amount of the elastomer is at least the above lower limit, a storage stability improvement effect can be achieved for the adhesive layer 31. Provided the amount of the elastomer is not more than the above upper limit, there is no reduction in the curing reactivity of the adhesive layer 31.

The adhesive layer 31 may also contain a reactive diluent, reaction accelerator, filler, or coupling agent or the like.

Any substance may be used as the reactive diluent, provided it is capable of adjusting the viscosity of the adhesive that constitutes the adhesive layer 31, but does not gasify during sealing of the main body of the electronic component package, and therefore does not affect the characteristics of the housed electronic component.

A reaction accelerator is used in those cases where the adhesive layer 31 requires curing in a short period of time under high temperature conditions. Examples of the reaction accelerator include imidazoles such as 2-ethyl-4-methylimidazole and 2-undecylimidazole, amines such as m-phenylenediamine, diaminodiphenyl ether and boron trifluoride monoethylamine complex, as well as triphenylphosphines and carboxylic acids.

Examples of the filler include silica, quartz powder, alumina, calcium carbonate, magnesium oxide, and zinc oxide.

Examples of the organic reactive group of the silane coupling agent include a vinyl group, alicyclic epoxy group, glycidyl group, methacrylic group, acrylic group, styryl group, amino group, diamino group, mercapto group, ureido group, and isocyanate group. Among these, a silane coupling agent having a glycidyl group is preferred.

In the electronic component sealing lid 30 of the present embodiment, the adhesive that constitutes the adhesive layer 31 is preferably liquid at room temperature. The viscosity at 25°C of the adhesive that constitutes the adhesive layer 31 is preferably at least 0.001 Pa·s but not more than 1,000 Pa·s. However, adhesives that are solid at room temperature but become liquid upon heating can also be used in the present embodiment.

The adhesive layer 31 in the electronic component sealing lid 30 of the present embodiment is obtained by applying the adhesive described above in a semi-cured state to form an arbitrary shape on the bonding surface 10a of the electronic component sealing lid 10. Here, the term "semi-cured state" refers to a state also called a B-stage state. This state describes a state in which two-dimensional reactions have progressed between the thermosetting resin and the curing agent resulting in the existence of linear polymer chains. The adhesive layer 31 in this state has the characteristics of the thermosetting resin, while also having the characteristics of a thermoplastic resin, meaning it melts upon heating, and undergoes reaction with a separate curing agent above a certain temperature, resulting in the progression of three-dimensional crosslinking reactions that yield an insoluble and infusible cured product.

Examples of the method used for forming the adhesive layer 31 on the bonding surface 10a of the electronic component sealing lid 10 include screen printing methods and dispensing methods. However, the method for forming the adhesive layer 31 is not limited to these methods, and any method that enables control of the dimensional precision and coating shape may be used.

Embodiments of the present invention have been described above in detail based on the drawings, but these embodiments are merely examples of the present invention. Accordingly, the present invention is not limited to the structures described in the embodiments, and any design modifications or the like that fall within the scope of the present invention are of course included within the present invention. Further, in those cases where any of the embodiments includes a plurality of structures, any combination of these structures is of course also included within the present invention, even if not specifically mentioned. Furthermore, in those cases where an embodiment describes a plurality of examples or modifications as being included within the present invention, any possible combination of structures spanning these examples or modifications is, of course, also included within the present invention, even if not specifically mentioned. Furthermore, the structures illustrated in the drawings are of course included within the present invention, even if not specifically mentioned. Moreover, the expressions "and the like", "or the like" and "such as" are used to mean that similar items are also included within the scope of the present invention.

[Examples]

The present invention is described below in further detail using a series of test examples, but the present invention is not limited to the following test examples.

[Test Examples]

(Electronic Component Sealing Lids)

The compounds a to c described below were used as the liquid crystal polymer.

a) Product name: SUMIKASUPER LCP E6008 (a polycondensate of phenol, phthalic acid and para-hydroxybenzoic acid) manufactured by Sumitomo Chemical Co., Ltd.
b) Product name: XYDAR M-350 (a polycondensate of phenol, phthalic acid and para-hydroxybenzoic acid) manufactured by ENEOS Corporation
c) UENO LCP UA (201) GS (a polycondensate of 2,6-hydroxynaphthoic acid and para-hydroxybenzoic acid) manufactured by Ueno Fine Chemicals Industry Ltd.

Resin compositions containing 100 parts by mass of one of the liquid crystal polymers a to c described above and 40 parts by mass of glass fiber were placed in a mold and compressed by cold pressing to mold a preformed body.

Subsequently, the preformed body was heated to a temperature of 360°C and injected into a mold under an injection pressure of 130 MPa, and then cooled and held for 15 seconds to obtain an electronic component sealing lid A (liquid crystal polymer: a) (length 6.34 mm × width 6.24 mm × thickness 1.5 mm), an electronic component sealing lid B (liquid crystal polymer: b) (length 6.34 mm × width 6.24 mm × thickness 1.5 mm), and an electronic component sealing lid C (liquid crystal polymer: c) (length 6.34 mm × width 6.24 mm × thickness 1.5 mm).

Next, the surface in each of these electronic component sealing lids A to C on which an adhesive layer was to be formed was subjected to lap polishing.

Subsequently, for this surface in each of the electronic component sealing lids A to C on which an adhesive layer was to be formed (namely, the lap polished surface), and the surface on which the adhesive layer was not to be formed (the surface that had not been lap polished), an absorbance distribution was measured by the ATR (Attenuated Total Reflection) method using a Fourier transform infrared spectrophotometer (FT-IR).

For both the surface in each of the electronic component sealing lids A to C on which an adhesive layer was to be formed (namely, the lap polished surface), and the surface on which the adhesive layer was not to be formed (the surface that had not been lap polished), the absorbance distribution was measured at six random locations, and the values for S1, S2, S3, S4, T1 and T2 were determined in the manner described above. The results are shown below in Table 1.

The numerical values for S1, S2, S3, and S4 in Table 1 are the average value across the six random locations, and the values for T1 and T2 are values calculated based on those average values.

[Table 1]

| Lid | Absorbance distribution measured surface | S1 | S2 | S3 | S4 | T1 | T2 | T1/T2 |
|---|---|---|---|---|---|---|---|---|
| A | Adhesive layer surface | 0.264 | 1.276 | - | - | 0.207 | - | 0.745 |
| | Non-adhesive layer surface | - | - | 0.576 | 2.071 | - | 0.278 | |

(continued)

| Lid | Absorbance distribution measured surface | S1 | S2 | S3 | S4 | T1 | T2 | T1/T2 |
|---|---|---|---|---|---|---|---|---|
| B | Adhesive layer surface | 0.316 | 1.104 | - | - | 0.286 | - | 1.192 |
| | Non-adhesive layer surface | - | - | 0.294 | 1.223 | - | 0.24 | |
| C | Adhesive layer surface | 0.466 | 1.173 | - | - | 0.397 | - | 1.01 |
| | Non-adhesive layer surface | - | - | 0.473 | 1.204 | - | 0.393 | |

(Adhesives)

<Adhesive a>

The materials listed below were kneaded using a three-roll mill, and the kneaded product was then subjected to vacuum degassing to obtain an adhesive a.

Thermosetting resin (bisphenol A epoxy resin) 100 parts by mass
Curing agent (diaminodiphenylmethane) 9.3 parts by mass
Stabilizer (epoxyphenol borate ester mixture) 10 parts by mass
Reaction accelerator (2,4-diamino-6-[2'-methylimadazolyl-(1')]-ethyl-S-triazine isocyanuric acid adduct) 2.5 parts by mass
Silane coupling agent (3-glycidoxypropyltrimethoxysilane) 1 part by mass
Elastomer (polyisoprene maleic anhydride adduct) 15 parts by mass
Filler (silica) 10 parts by mass

<Adhesive b>

With the exception of removing the silane coupling agent from the materials listed above for the adhesive a, an adhesive b was obtained in the same manner as the adhesive a.

(Evaluations)

The adhesive a was applied to the edge portions of the electronic component sealing lids A to C in sufficient amount to form a width of 0.5 mm, and the adhesive a was then heated and dried to form a semi-cured state, thus forming an adhesive layer composed of the adhesive a.

Each of the electronic component sealing lids A to C having the adhesive layer composed of the adhesive a formed thereon was mounted on a copper sheet, and the resulting structure was heated at 90°C for one hour while a 2 kg load was applied, thus completely curing the adhesive layer.

Further, the adhesive b was also applied to the edge portions of the electronic component sealing lids A to C in sufficient amount to form a width of 0.5 mm, and the adhesive b was then heated and dried to form a semi-cured state, thus forming an adhesive layer composed of the adhesive b.

Each of the electronic component sealing lids A to C having the adhesive layer composed of the adhesive b formed thereon was mounted on a copper sheet, and the resulting structure was heated at 90°C for one hour while a 2 kg load was applied, thus completely curing the adhesive layer.

Each of the lids bonded to a copper sheet obtained in the manner described above was subjected to the tests described below. The results are shown in Table 2.

(1) Adhesive Strength Test

The copper sheet was secured, claws were hooked onto the electronic component sealing lid, a pulling load (shearing) was applied in the horizontal direction at a pull speed of 50 mm/minute, and the state of the electronic component sealing lid was observed. If the electronic component sealing lid had undergone absolutely no detachment from the copper sheet, an evaluation of "A" was recorded, if the electronic component sealing lid had partially detached from the copper sheet, an evaluation of "B" was recorded, and if the electronic component sealing lid had detached completely from the copper sheet, an evaluation of "C" was recorded.

(2) Reflow Test

Each of the electronic component sealing lids bonded to a copper sheet was subjected to three repetitions of retention for 30 seconds in a reflow tank at a temperature of 260°C, and the state of the electronic component sealing lid was then inspected. If the electronic component sealing lid had undergone absolutely no detachment from the copper sheet, an evaluation of "A" was recorded, if the electronic component sealing lid had partially detached from the copper sheet, an evaluation of "B" was recorded, and if the electronic component sealing lid had detached completely from the copper sheet, an evaluation of "C" was recorded.

(3) High-Temperature High-Humidity Test

Each of the electronic component sealing lids bonded to a copper sheet was left to stand for 1,000 hours in a tank at a temperature of 85°C and a humidity of 85%, and the state of the electronic component sealing lid was then inspected. If the electronic component sealing lid had undergone absolutely no detachment from the copper sheet, an evaluation of "A" was recorded, if the electronic component sealing lid had partially detached from the copper sheet, an evaluation of "B" was recorded, and if the electronic component sealing lid had detached completely from the copper sheet, an evaluation of "C" was recorded.

[Table 2]

| Lid | Adhesive | | Adhesive strength test | Reflow test | High-temperature high-humidity test |
|---|---|---|---|---|---|
| A | Adhesive a | - | A | A | A |
| B | | | A | A | A |
| C | | | C | C | C |
| A | - | Adhesive b | B | B | B |
| B | | | B | B | B |
| C | | | C | C | C |

Based on the results in Table 2, it was evident that the electronic component sealing lid A that satisfies the relationship T1/T2 < 0.9 and the electronic component sealing lid B that satisfies the relationship T1/T2 > 1.1 yielded favorable results, with no detachment in the adhesive strength test, the reflow test or the high-temperature high-humidity test. The electronic component sealing lids that included the adhesive layer formed from the adhesive a which contained the latent curing agent yielded particularly favorable results.

In contrast, the electronic component sealing lid C for which T1/T2 was within a range from at least 0.9 to not more than 1.1 suffered from detachment in the adhesive strength test, the reflow test and the high-temperature high-humidity test.

[Industrial Applicability]

The electronic component sealing lid of the present invention contains a liquid crystal polymer, and yet exhibits improved adhesiveness with the adhesive at the bonding surface with the main body of an electronic component package, and suppresses detachment from the main body of the electronic component package caused by reflow treatment. As a result, the electronic component sealing lid of the present invention can be used favorably in electronic component packages for sealing the electronic component.

[Reference Signs List]

10, 30: Electronic component sealing lid
11: Base section
12: Wall section
20: Space
31: Adhesive layer

## Claims

1. An electronic component sealing lid,

which is formed from a resin composition comprising a liquid crystal polymer and an inorganic substance, and satisfies either formula (a) or formula (b) shown below:

$$T1/T2 < 0.9 \qquad (a)$$

$$T1/T2 > 1.1 \qquad (b)$$

wherein T1=S1/S2, T2=S3/S4, S1 is an area of a region obtained by connecting, with a straight line, an inverse peak nearest to 900 $cm^{-1}$ and an inverse peak nearest to 860 $cm^{-1}$ in an absorbance distribution, measured by Fourier transform infrared spectroscopy, of the resin composition of an bonding surface of the electronic component sealing lid, S2 is an area of a region obtained by connecting, with a straight line, an inverse peak nearest to 900 $cm^{-1}$ and an inverse peak nearest to 770 $cm^{-1}$ in an absorbance distribution, measured by Fourier transform infrared spectroscopy, of the bonding surface of the electronic component sealing lid, S3 is an area of a region obtained by connecting, with a straight line, an inverse peak nearest to 900 $cm^{-1}$ and an inverse peak nearest to 860 $cm^{-1}$ in an absorbance distribution, measured by Fourier transform infrared spectroscopy, of a surface of a portion of the electronic component sealing lid that is not the bonding surface, and S4 is an area of a region obtained by connecting, with a straight line, an inverse peak nearest to 900 $cm^{-1}$ and an inverse peak nearest to 770 $cm^{-1}$ in an absorbance distribution, measured by Fourier transform infrared spectroscopy, of the surface of the portion of the electronic component sealing lid that is not the bonding surface.

2. The electronic component sealing lid according to Claim 1, wherein an arithmetic average roughness (Ra) of the bonding surface of the electronic component sealing lid is at least 0.3 $\mu$m but not more than 20 $\mu$m.

3. The electronic component sealing lid according to Claim 1 or 2, wherein an amount of the inorganic substance is at least 10 parts by mass but not more than 60 parts by mass per 100 parts by mass of the liquid crystal polymer.

4. The electronic component sealing lid according to Claim 2 or 3, wherein an adhesive layer is laminated onto the bonding surface, and the adhesive layer comprises a thermosetting resin and a curing agent.

5. The electronic component sealing lid according to Claim 4, wherein the adhesive layer comprises a silane coupling agent.

6. The electronic component sealing lid according to Claim 4 or 5, wherein an amount of the thermosetting resin is at least 1% by mass but not more than 80% by mass of a total mass of the adhesive layer.

7. The electronic component sealing lid according to any one of Claims 4 to 6, wherein a content ratio of the curing agent relative to the thermosetting resin, expressed as an equivalence ratio, is at least 0.2 but not more than 1.

FIG. 1A

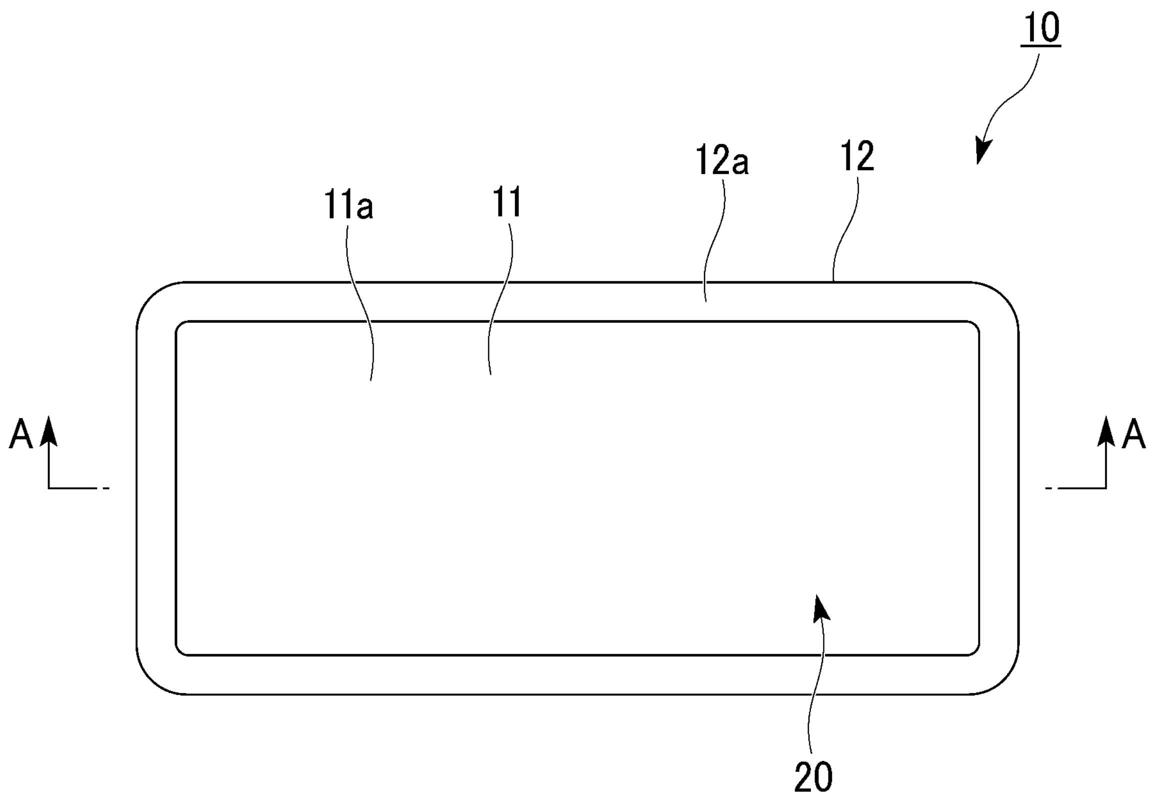


FIG. 1B

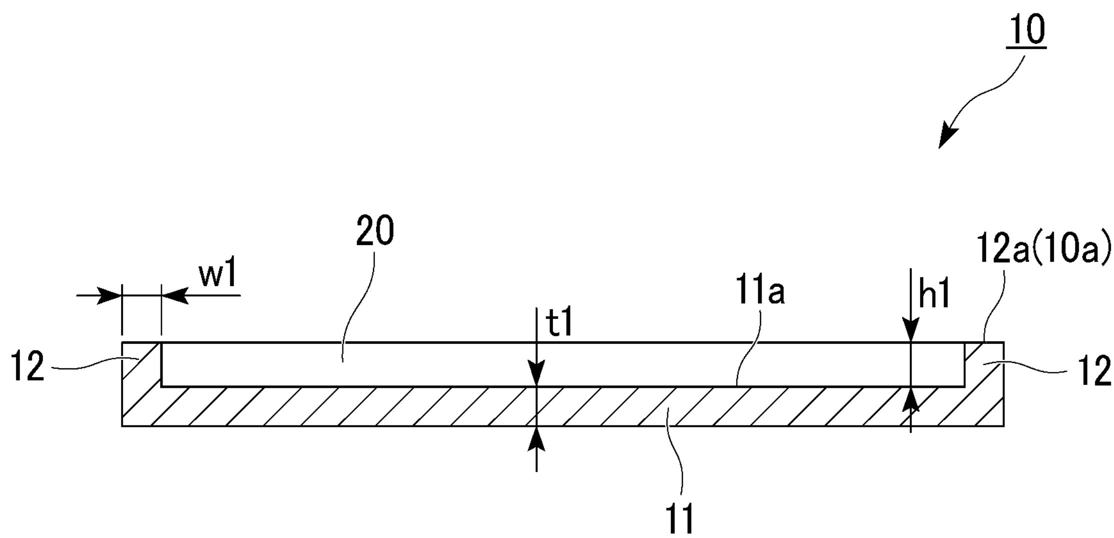

FIG. 2

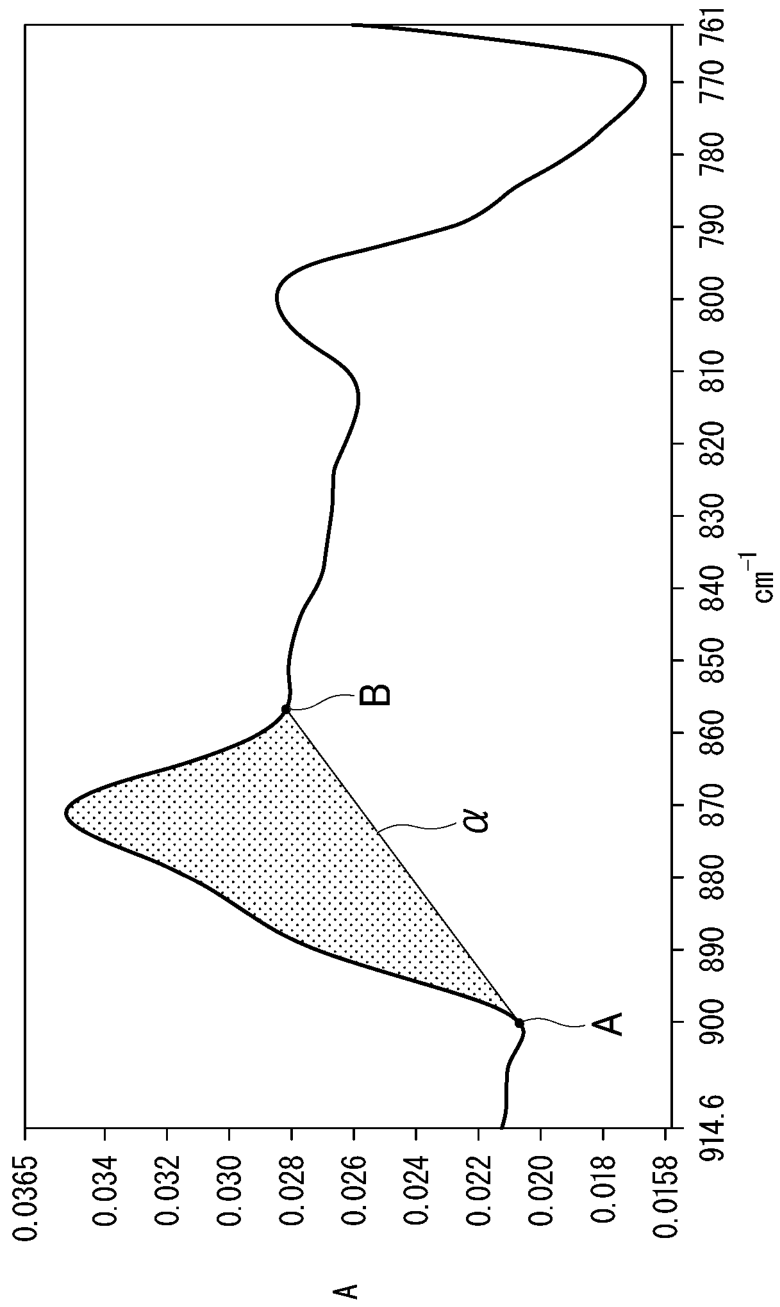
A
0.0365
0.034
0.032
0.030
0.028
0.026
0.024
0.022
0.020
0.018
0.0158
914.6
900
890
880
870
860
850
840
830
820
810
800
790
780
770
761
cm⁻¹
A
B
α

FIG. 3

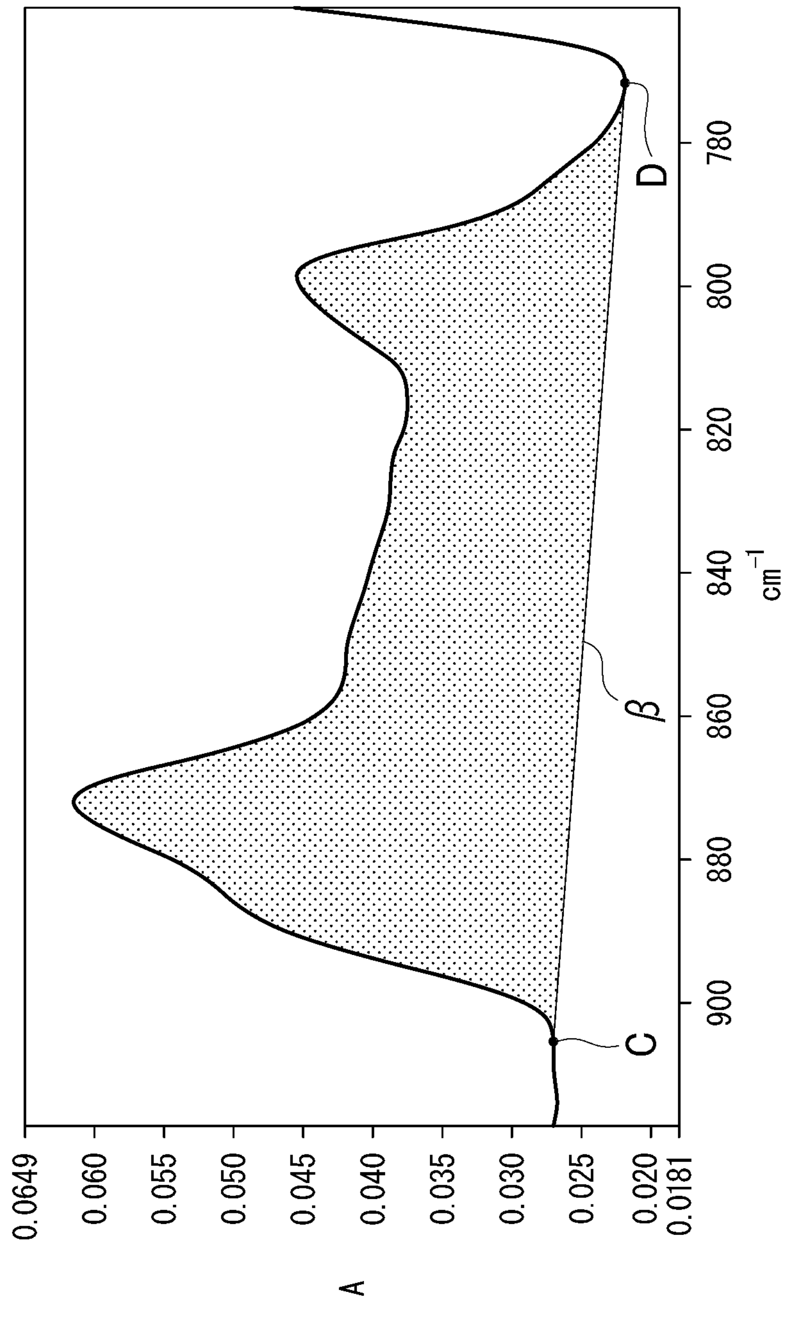
A
0.0649
0.060
0.055
0.050
0.045
0.040
0.035
0.030
0.025
0.020
0.0181
900
880
860
840
820
800
780
cm$^{-1}$
C
D
β

FIG. 4

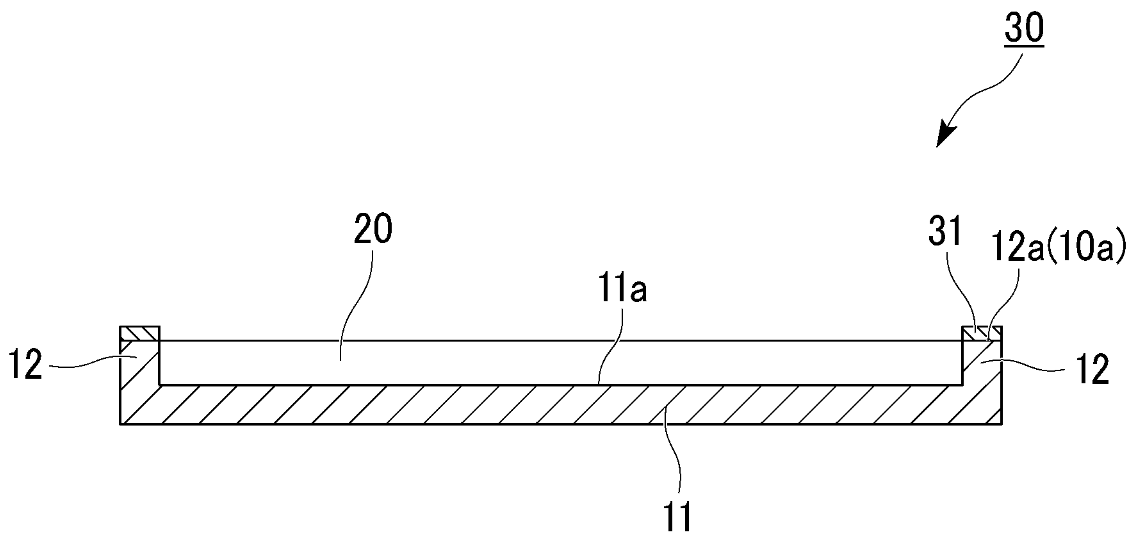

**INTERNATIONAL SEARCH REPORT**

International application No.
**PCT/JP2022/009119**

**A. CLASSIFICATION OF SUBJECT MATTER**

***H01L 23/02***(2006.01)i; ***H01L 23/10***(2006.01)i
FI: H01L23/02 J; H01L23/10 B

According to International Patent Classification (IPC) or to both national classification and IPC

**B. FIELDS SEARCHED**

Minimum documentation searched (classification system followed by classification symbols)

H01L23/02; H01L23/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 4-116852 A (MITSUI PETROCHEM IND LTD) 17 April 1992 (1992-04-17)<br>p. 2, lower left column, line 5 to p. 3, lower left column, line 9, fig. 1-3 | 1-7 |
| A | JP 2004-343684 A (MURATA MANUFACTURING CO., LTD.) 02 December 2004 (2004-12-02)<br>paragraphs [0013]-[0023], fig. 1-5 | 1-7 |

☐ Further documents are listed in the continuation of Box C.

☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 May 2022** | **31 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/009119**

| Patent document cited in search report | Publication date (day/month/year) | Patent family member(s) | Publication date (day/month/year) |
|---|---|---|---|
| JP 4-116852 A | 17 April 1992 | (Family: none) | |
| JP 2004-343684 A | 02 December 2004 | US 2004/0218769 A1<br>paragraphs [0022]-[0050], fig. 1-5<br>EP 1471769 A2<br>KR 10-0608448 B1<br>CN 1541026 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021037215 A
- JP 2016076669 A
- JP 1236246 A